# DEMANDE DE BREVET EUROPEEN

(11) **EP 4 300 553 A1**
(43) Date de publication de la demande: **03.01.2024**
(21) Numéro de dépôt: 23180309.9
(22) Date de dépôt: 20.06.2023
(51) Int. Cl.: H01L 21/56, H01L 21/60, H01L 23/31, H01L 21/683, H01L 21/78

(54) **COLLAGE AUTO-ALIGNÉ PAR CONTRASTE D'HYDROPHILIE**

(30) Priorité: 28.06.2022 FR 2206445
(71) Demandeur: Commissariat à l'énergie atomique et aux énergies alternatives, 75015 Paris (FR)
(72) Inventeur: MONTMEAT, Pierre, 38054 GRENOBLE CEDEX 09 (FR); FOURNEL, Franck, 38054 GRENOBLE CEDEX 09 (FR); ENOT, Thierry, 38054 GRENOBLE CEDEX 09 (FR)
(74) Mandataire: Cabinet Beaumont

(57) **Abrégé**

La présente description concerne un procédé de fabrication d'une structure destinée à être assemblée avec une autre structure par collage auto-aligné par contraste d'hydrophilie, comportant les étapes successives suivantes :
a) définition de plots (15) du côté d'une première face d'un premier substrat (11) ;
b) report d'un deuxième substrat (27) du côté de la première face du premier substrat (11) ;
c) formation, sur les flancs et/ou sur une partie périphérique de la face supérieure des plots (15), d'un matériau (25) plus hydrophobe qu'un matériau de la face supérieure des plots ; et
d) retrait du deuxième substrat (27).

## Description

### Domaine technique

La présente description concerne de façon générale le collage de deux structures et plus particulièrement le collage auto-aligné par contraste d'hydrophilie.

### Technique antérieure

Un collage auto-aligné par contraste d'hydrophilie consiste en le collage de deux structures dont l'alignement est contrôlé par une goutte d'eau déposée sur l'une des deux structures. Dans un tel collage, on vient déposer une goutte d'eau à la surface d'une première structure présentant une zone généralement plus hydrophile, la goutte d'eau par différence d'hydrophilie se confinant sur cette zone. La deuxième structure reportée, comportant également une zone plus hydrophile, s'aligne par traction de la goutte d'eau, avec la première structure de façon que la zone hydrophile de la deuxième structure fasse face à la zone hydrophile de la première structure.

Il existe un besoin d'amélioration des procédés de collage auto-aligné et plus particulièrement de la fabrication de structures destinées à un tel collage.

### Résumé de l'invention

Un mode de réalisation prévoit un procédé de fabrication d'une structure destinée à être assemblée avec une autre structure par collage auto-aligné par contraste d'hydrophilie, comportant les étapes successives suivantes :
- définition de plots du côté d'une première face d'un premier substrat ;
- report d'un deuxième substrat du côté de la première face du premier substrat ;
- formation, sur les flancs et/ou sur une partie périphérique de la face supérieure des plots, d'un matériau plus hydrophobe qu'un matériau de la face supérieure des plots ; et
- retrait du deuxième substrat.

Selon un mode de réalisation, le matériau de la face supérieure des plots et le matériau revêtant le flanc des plots présentent une différence d'angle de contact de goutte d'eau supérieure à 20°.

Selon un mode de réalisation, le premier substrat comprend un matériau semiconducteur.

Selon un mode de réalisation, le premier substrat est un substrat de type semiconducteur sur isolant.

Selon un mode de réalisation, la première face du premier substrat est revêtue d'une couche d'oxyde.

Selon un mode de réalisation, la couche d'oxyde sur le premier substrat comprend des plots de connexion métalliques.

Selon un mode de réalisation, à l'étape b), le deuxième substrat est fixé au premier substrat par collage moléculaire.

Selon un mode de réalisation, l'étape c) est réalisée par traitement HF vapeur.

Selon un mode de réalisation, l'étape c) est réalisée par immersion de la structure dans un bain à base d'un composé fluoré.

Selon un mode de réalisation, l'étape c) est réalisée par immersion de la structure dans un bain à base du mélange connu sous la dénomination commerciale optool, à base de octadecyltrichlorosilaneou à base de perfluorodecyldimethylchlorosilane.

Selon un mode de réalisation, le procédé comporte, avant l'étape c), une étape de découpe du premier substrat, de façon à former des puces, chaque puce comportant un plot.

Selon un mode de réalisation, le procédé comporte, après l'étape a), une étape de nettoyage de la première face du premier substrat.

Selon un mode de réalisation, le deuxième substrat est structuré de façon à présenter un plot d'épaisseur non nulle en vis à vis de chaque plot du premier substrat.

Selon un mode de réalisation, les plots du premier substrat ont une épaisseur non nulle.

Un autre mode de réalisation prévoit un procédé de collage d'une première structure et d'une deuxième structure fabriquée par le procédé défini ci-dessus, le procédé de collage comportant une étape de dépôt d'une goutte d'eau sur la première face du premier substrat de la première structure et une étape de report de la deuxième structure sur la première structure, les premières faces des premiers substrats se faisant face.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1A, la figure 1B, la figure 1C, la figure 1D, la figure 1E, la figure 1F, la figure 1G et la figure 1H sont des vues en coupe, illustrant de façon partielle et schématique, des étapes successives d'un exemple de procédé de fabrication puis d'assemblage de deux structures par collage ;
la figure 2A, la figure 2B, la figure 2C, la figure 2D, la figure 2E, la figure 2F, la figure 2G et la figure 2H sont des vues en coupe, illustrant de façon partielle et schématique, des étapes successives d'un procédé de fabrication puis d'assemblage de deux structures par collage selon un premier mode de réalisation ;
la figure 3A, la figure 3B, la figure 3C et la figure 3D sont des vues en coupe, illustrant de façon partielle et schématique, des étapes successives d'un procédé de fabrication puis d'assemblage de deux structures par collage selon un deuxième mode de réalisation ;
la figure 4A, la figure 4B, la figure 4C, la figure 4D, la figure 4E et la figure 4F sont des vues en coupe, illustrant de façon partielle et schématique, des étapes successives d'un procédé de fabrication puis d'assemblage de deux structures par collage selon un troisième mode de réalisation ; et
la figure 5A et la figure 5B sont des vues en coupe, illustrant de façon partielle et schématique, des étapes successives d'un procédé d'assemblage de deux structures par collage selon un quatrième mode de réalisation.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés. En particulier, seule la mise en forme des structures a été décrite. Les fonctionnalités que comportent ces structures n'ont pas été décrites.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures.

Sauf précision contraire, les expressions "environ", "approximativement", "sensiblement", et "de l'ordre de" signifient à 10 % près, de préférence à 5 % près.

Dans la suite de la description, une couche est dite hydrophile lorsque la mesure de l'angle de goutte ou angle de contact, c'est à dire l'angle formé entre la tangente à la goutte et la surface de la couche, pour une goutte d'eau, est inférieure à 60°, de préférence inférieure à 30°. Par ailleurs, une couche est dite hydrophobe lorsque la mesure de l'angle de goutte, pour une goutte d'eau, est supérieure à 60 °, par exemple supérieure à 70°. Par ailleurs, une couche est dite plus hydrophile ou moins hydrophobe qu'une autre couche lorsque l'angle de contact d'une goutte d'eau sur la surface de la couche, est inférieur à l'angle de contact d'une goutte d'eau sur la surface de l'autre couche.

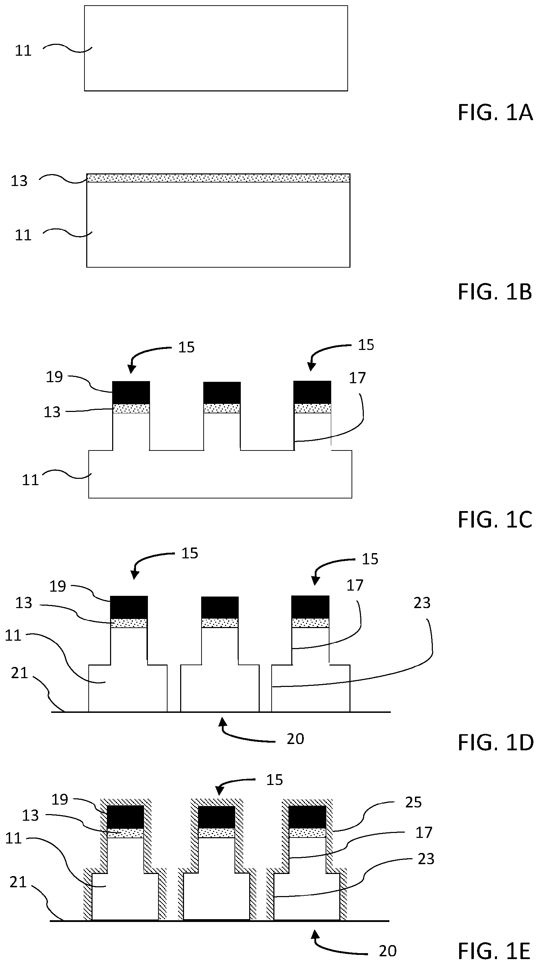

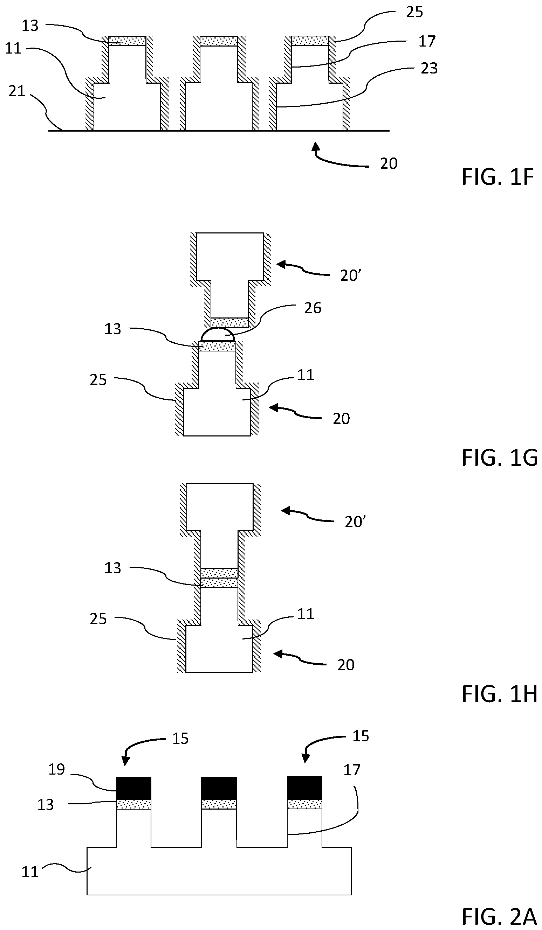

La figure 1A, la figure 1B, la figure 1C, la figure 1D, la figure 1E, la figure 1F, la figure 1G et la figure 1H sont des vues en coupe, illustrant de façon partielle et schématique, des étapes successives d'un exemple de procédé de fabrication puis d'assemblage de deux structures par collage.

La figure 1A illustre un substrat 11 de départ. A titre d'exemple, le substrat 11 est en un matériau semiconducteur. A titre d'exemple, le substrat 11 est en silicium, par exemple monocristallin.

Le substrat 11 correspond, par exemple, à une plaquette, par exemple de forme générale circulaire dont le diamètre est compris entre 100 mm et 300 mm, par exemple de l'ordre de 200 mm, ou à une portion de plaquette. A titre d'exemple, le substrat 11 a une épaisseur comprise entre 100 µm et 1 mm, par exemple comprise entre 500 µm et 800 µm, par exemple de l'ordre de 725 µm.

A titre d'exemple, des circuits ou éléments intégrés sont formés dans et/ou sur le substrat 11, par exemple du côté de la face supérieure du substrat 11. A titre d'exemple, le substrat 11 peut comprendre, du côté de sa face supérieure un empilement d'un ou plusieurs niveaux diélectriques et d'un ou plusieurs niveaux électriquement conducteurs, par exemple métalliques, alternés, formant un empilement d'interconnexion (non détaillé sur la figure) dans lequel sont formés des éléments de connexion des circuits intégrés dans et/ou sur le substrat 11.

La figure 1B illustre une structure obtenue à l'issue d'une étape de dépôt d'une couche isolante 13 sur la face supérieure du substrat 11 illustré en figure 1A. A titre d'exemple, la couche 13 est en un oxyde, par exemple en dioxyde de silicium (SiO₂).

A titre d'exemple, la couche 13 est formée, par exemple par dépôt chimique en phase vapeur (CVD, de l'anglais "Chemical Vapor Déposition") à partir de silane (SiH₄). A titre d'exemple, le dépôt est suivi d'un recuit à haute température, par exemple à une température supérieure à 400°C.

Après dépôt, la couche 13 est, par exemple planarisée, par exemple, par une planarisation mécanique ou mécano-chimique (CMP, de l'anglais "Chemical Mechanical Polishing"). A titre d'exemple, la couche 13 a, après planarisation, une épaisseur comprise entre 100 nm et 3 µm, par exemple de l'ordre de 2 µm. La couche 13 s'étend par exemple de façon continue et avec une épaisseur sensiblement uniforme sur toute la surface supérieure du substrat 11.

En variante, la couche 13 comprend une pluralité de motifs métalliques, par exemple, en cuivre, séparés latéralement par un matériau isolant, par exemple un oxyde, par exemple du dioxyde de silicium. A titre d'exemple, les motifs correspondent à des plots, par exemple d'une surface comprise entre 1 µm² et 625 µm², par exemple de l'ordre de 10 µm². A titre d'exemple, deux motifs voisins sont espacés d'une distance comprise entre 1 µm et 30 µm, par exemple de l'ordre de 3 µm. Dans cette variante, la surface de la couche 13 est alors une surface hybride métal et oxyde, par exemple cuivre et oxyde de silicium.

Dans la suite de la description, on désigne par face avant, la face supérieure de la structure dans l'orientation de la figure 1B et par face arrière, la face inférieure de la structure dans l'orientation, de la figure 1B.

La figure 1C illustre une structure obtenue à l'issue d'une étape de formation de tranchées 17 dans la structure de la figure 1B, délimitant latéralement des plots 15. Les tranchées 17 sont, par exemple, formées par gravure. Pour ce faire, une couche de résine photosensible 19 est, par exemple, déposée sur la face supérieure de la couche 13. La couche 19 est ensuite exposée aux ultraviolets (UVs) localement à travers un masque de photolithographie puis développée afin de former des motifs dans la couche 19. A titre d'exemple, la résine de la couche 19 est une résine positive ou négative. A l'issue de cette étape, seules des portions de la couche 19 subsistent en vis-à-vis des plots 15 à former. Une étape de gravure permet ensuite de former des ouvertures ou tranchées 17, à partir de la face supérieure de la structure dans la couche 13 et le substrat 11, en utilisant les motifs préalablement formés dans la couche 19 comme masque de gravure. Les tranchées 17 sont, par exemple, non traversantes c'est-à-dire qu'elles ne débouchent pas sur la face inférieure du substrat 11. Les plots 15 sont, par exemple, formés de la couche 19, la couche 13 et une partie du substrat 11.

A titre d'exemple, si le substrat 11 comprend des circuits électroniques intégrés, chaque plot 15 comprend un circuit. La largeur des plots 15 est alors supérieure à la largeur des circuits intégrés. Les plots 15 sont par exemple tous identiques, aux dispersions de fabrication près.

A titre d'exemple, plusieurs dizaines de plots 15 sont formés dans une même plaque de substrat 11. A titre d'exemple, chaque plot 15 a une surface comprise entre 1 mm² et 1600 mm², par exemple entre 9 mm² et 900 mm², par exemple de l'ordre de 3mm x 3 mm ou 8 mm x 8 mm.

Les tranchées 17 s'étendent, par exemple sur une profondeur, à partir de la face supérieure du substrat 11, comprise entre 1 µm et 50 µm, par exemple entre 1 µm et 30 µm, par exemple entre 5 µm et 15 µm.

A titre d'exemple, lors l'étape de formation des plots 15, si la couche 13 correspond à une couche hybride métal-oxyde, plusieurs gravures successives peuvent être prévues pour former les tranchées 17. A titre d'exemple, après la formation de la couche 19, en vis-à-vis des plots 15 à former, une première gravure, par exemple humide, permet de retirer des motifs métalliques non protégés par la couche 19 puis une deuxième gravure, par exemple par plasma, permet de retirer l'oxyde et une partie de l'épaisseur du substrat 11 non protégées par la couche 19.

La figure 1D illustre une structure obtenue à l'issue d'une étape de découpe de la structure illustrée en figure 1C de façon à former des puces individuelle 20. Avant l'étape de découpe, la structure illustrée en figure 1C est, par exemple, montée sur un film support 21, par exemple un film adhésif, lui-même monté tendu sur un cadre rigide (non visible sur la figure). Dans cet exemple, le substrat 11 est fixé, par sa face arrière, sur la face supérieure du film support 21. L'étape de découpe est, par exemple, réalisée à l'aide d'une scie diamantée. Lors de cette étape, on vient former, dans la structure illustrée en figure 1C, des tranchées 23, en vis-à-vis des tranchées 17. Les tranchées 23 sont, par exemple traversantes et s'étendent, par exemple, du fond des tranchées 17 jusqu'à la face inférieure du substrat 11. Les tranchées 23 sont par exemple centrées sur les tranchées 17 sus-jacentes. A titre d'exemple, les tranchées 23 ont une largeur inférieure à la largeur des tranchées 17.

A titre d'exemple, les tranchées 23 sont formées de façon à former des puces 20, chaque puce 20 comportant un unique plot 15.

La figure 1E illustre une structure obtenue à l'issue d'une étape de dépôt d'une couche hydrophobe 25 sur la face supérieure de la structure illustrée en figure 1D.

L'étape de dépôt est, par exemple, suivie d'un recuit permettant, par exemple, de réticuler et stabiliser le composé hydrophobe.

A l'issue de l'étape de dépôt, la couche 25 recouvre la face supérieure de la structure illustrée en figure 1D c'est-à-dire la face supérieure de la couche 19, la face supérieure du film 21, les flancs de la couche 13 et les flancs du substrat 11 dans les tranchées 17 et 23.

La figure 1F illustre une structure obtenue à l'issue d'une étape de retrait de la couche 19 de la structure illustrée en figure 1E. Lors de cette étape, la couche 19 est intégralement retirée de la structure, par exemple par voie chimique ou plasma.

Le retrait de la couche 19 entraine le retrait de la portion de la couche 25 située à l'aplomb de la couche 19. L'étape de retrait est par exemple suivie d'une étape de nettoyage de la surface des plots 15 et plus précisément de la face supérieure de la couche 13. En effet, des particules ou contaminants organiques issues de la couche 19 peuvent subsister, à l'issue de l'étape de retrait de la couche 19, sur la face supérieure de la couche 13. Ces contaminants peuvent avoir un impact négatif sur le futur collage ou sur des étapes postérieures au collage.

A l'issue de l'étape de retrait de la couche 19, la couche 25 subsiste sur les flancs des puces 20, c'est-à-dire sur les flancs du substrat 11 et de la couche 13 et sur la face supérieure du cadre 21. Ainsi, les flancs des puces 20 et la face supérieure de la couche 13 ont une différence d'hydrophilie. En effet, le matériau de la couche 25 est choisi pour être plus hydrophobe que le ou les matériaux de la face supérieure de la couche 13, par exemple hydrophiles.

A titre d'exemple, après cette étape, les puces 20 sont détachées du film support 21. A titre d'exemple, les puces 20 sont prélevées individuellement ou collectivement sur le film support 21 pour être assemblées sur une autre structure.

La figure 1G illustre une structure obtenue à l'issue d'une étape de dépôt d'une goutte d'eau 26 à la surface d'une puce 20 formée par le procédé décrit ci-avant en relation avec les 1A à 1F et le report, sur une autre structure présentant une surface d'accueil présentant un contraste d'hydrophilie similaire à celui de la face avant de la puce 20. A titre d'exemple, la puce 20 est reportée sur une autre puce 20', elle-même formée par un procédé identique ou similaire au procédé des figures 1A à 1F, les couches 13 des deux puces se faisant face.

La différence d'hydrophilie entre la face avant et les flancs des puces 20 permet à la goutte d'eau 26 d'être confinée sur la face avant des puces 20 qui est plus hydrophile que les flancs. Lors du report de la puce 20', celle-ci est attirée, plus précisément la face avant de la puce 20' est attirée, par la goutte d'eau 26 et les deux puces 20 s'auto-alignent par capillarité.

A titre d'exemple, les puces peuvent être manipulées individuellement, par exemple par des outils de manipulation de puces (pick and place) et/ou collectivement avec l'utilisation de plaques porte-puces.

La figure 1H illustre une structure finale de deux puces assemblées par collage. A titre d'exemple, l'étape de report illustrée en figure 1G est suive d'une étape de recuit ou évaporation de la goutte d'eau 26.

Le collage entre les structures 20 et 20' est par exemple un collage direct (sans apport de matière adhésive), aussi appelé collage moléculaire, de la face avant de la structure 20 sur la face avant de la structure 20'. Le collage peut être un collage direct diélectrique sur diélectrique, ou un collage hybride métal-diélectrique sur métal-diélectrique. A titre de variante, le collage peut être un collage direct métal-métal.

Le procédé tel que décrit en figures 1A à 1G permet l'assemblage de structures avec une très bonne précision et ce sans l'assistance d'un appareil d'alignement.

Toutefois, il a été constaté que le retrait de la couche 19 nécessite l'utilisation de méthodes de nettoyage agressives qui peuvent conduire à endommager la couche hydrophobe 25 sur au moins une partie supérieure (dans l'orientation de la figure 1F) des flancs des puces 20.

Par ailleurs, l'étape d'individualisation des puces par découpe à la scie diamantée décrite en relation avec la figure 1D peut engendrer une contamination métallique et particulaire de la structure.

Dans les modes de réalisation décrits ci-après, on prévoit de fabriquer des structures destinées à être assemblées par collage auto-aligné par contraste d'hydrophilie en protégeant la face avant des structures, lors de l'étape de dépôt de la couche hydrophobe, avec une plaque d'un substrat.

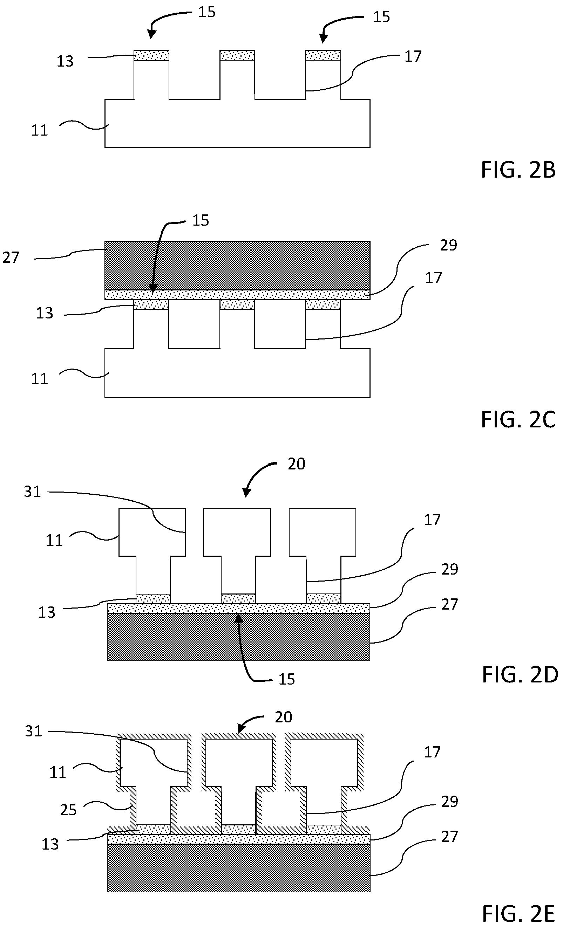

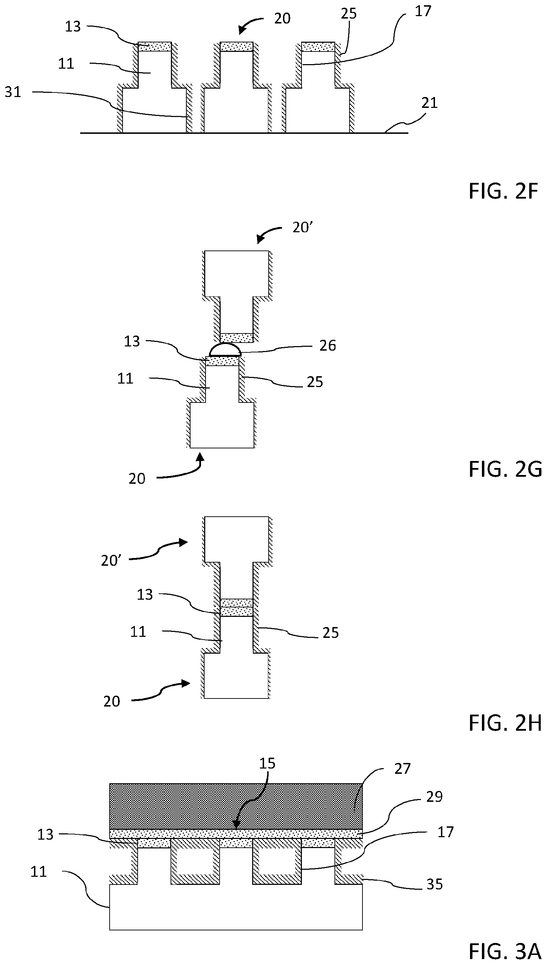

La figure 2A, la figure 2B, la figure 2C, la figure 2D, la figure 2E, la figure 2F, la figure 2G et la figure 2H sont des vues en coupe, illustrant de façon partielle et schématique, des étapes successives d'un procédé de fabrication puis d'assemblage de deux structures par collage selon un premier mode de réalisation.

Le procédé décrit en figures 2A à 2H comprend des étapes similaires à certaines étapes du procédé décrit en figures 1A à 1H. Ces étapes ne seront pas détaillées à nouveau ci-après. Seules les différences avec le procédé des figures 1A à 1H seront mises en exergue.

A partir de la structure illustrée figure 2A, obtenue à l'issue d'étapes identiques aux étapes 1A à 1C mais non représentées de nouveau, le procédé comprend une étape de retrait de la couche 19 de façon à former la structure illustrée en figure 2B. Dans ce mode de réalisation, l'étape de retrait de la couche 19 suit alors l'étape de formation des tranchées 17. En particulier, la couche 19 est retirée avant le dépôt de la couche hydrophobe.

Lors de cette étape, la couche 19 est retirée et la surface de la couche 13, par exemple, nettoyée. A titre d'exemple, la surface de la couche 13 est, par exemple nettoyée par une solution chimique sèche ou humide.

A titre d'exemple, la surface de la couche 13 est nettoyée en suivant la méthode dite RCA.

En variante, la surface de la couche 13 est nettoyée à l'aide d'un mélange de peroxyde sulfurique composé d'acide sulfurique et d'eau oxygénée, par exemple respectivement en proportion cinq pour un. Dans cette variante, la surface de la couche 13 est rincée puis nettoyée de nouveau à l'aide d'un mélange, par exemple à 70°C, composé d'eau, d'ammoniaque et d'eau oxygénée, par exemple respectivement en proportion cinq pour un pour un.

Encore en variante, la surface de la couche 13 est nettoyée à l'aide d'un mélange connu sous la dénomination commerciale EKC PCMP5650. Dans cette variante, le nettoyage de la couche 13 est réalisé sous UV et/ou ozone.

D'autres procédés de nettoyage peuvent être utilisés. En particulier, dans la mesure où il n'y a à ce stade pas de couche hydrophobe à protéger, de nombreux procédés de nettoyage peuvent être envisagés.

A l'issue de cette étape, la face supérieure des plots 15 et plus particulièrement la face supérieure de la couche 13, est dépourvue de tous résidus de couche 19. Dans ce mode de réalisation, la couche 19 n'a qu'un rôle de masque pour la gravure des tranchées 17 contrairement à l'exemple décrit en figures 1A à 1H dans lequel la couche 19 a également un rôle de protection de la face supérieure de la couche 13 lors du dépôt de la couche hydrophobe 25.

La figure 2C illustre une structure obtenue à l'issue d'une étape de report d'un substrat 27 sur la face supérieure de la structure illustrée en figure 2B. A titre d'exemple, le substrat 27 est revêtu d'une couche 29 sur la face inférieure dans l'orientation de la figure 2C, dite face avant. A titre d'exemple, le substrat 27 est un substrat semiconducteur, par exemple en silicium. A titre d'exemple, le substrat 27 correspond à une plaque de même diamètre que le substrat 11. A titre d'exemple, le substrat 27 a une épaisseur supérieure à 100 µm, de préférence supérieure à 200 µm, par exemple comprise entre 200 µm et 1 mm, par exemple comprise entre 500 µm et 800 µm, par exemple de l'ordre de 725 µm. A titre d'exemple, la couche 29 est en le même matériau que la couche 13. La couche 29 est, par exemple, en un oxyde, par exemple en dioxyde de silicium. La couche 29 a, par exemple une épaisseur comprise entre 200 nm et 10 µm, par exemple de l'ordre de 1 µm. La couche 29 est, par exemple, formée pleine plaque sur toute la surface du substrat 27. A titre d'exemple, avant le report du substrat 27 et de la couche 29 sur la structure illustrée en figure 2B, la face inférieure de la couche 29, dans l'orientation de la figure 2C, c'est-à-dire la face de la couche 29 opposée au substrat 27 est nettoyée par un procédé identique au procédé de nettoyage de la face supérieure de la couche 13.

Le report du substrat 27 sur la face supérieure de la structure illustrée en figure 2B est réalisé de sorte que la couche 29 soit en contact direct avec la couche 13. A titre d'exemple, le collage mis en oeuvre à cette étape est un collage direct ou collage moléculaire de la face supérieure de la couche 13 sur la face inférieure de la couche 29.

Dans cet exemple, le substrat 27 est non structuré, c'est à dire que la face inférieure du substrat 27 et la face inférieure de la couche 29 sont planes et s'étendent de façon continue sur toute la surface de substrat 11. A l'issue de cette étape, le substrat 27 et la couche 29 s'étendent sur les plots 15 et au-dessus des tranchées 17.

La figure 2D illustre une structure obtenue à l'issue d'une étape formation de puces individuelles 20 par la découpe ou la gravure de la structure illustrée en figure 2C. En figure 2D, la structure est représentée retournée par rapport à la structure illustrée en figure 2C. La face avant de la structure illustrée en figure 2C correspond alors à la face inférieure de la structure illustrée en figure 2D.

Lors de cette étape, on vient former, à partir de la face supérieure (face arrière) du substrat 11, des tranchées 31, en vis-à-vis des tranchées 17. Les tranchées 31 sont, par exemple traversantes et s'étendent, par exemple, de la face supérieure (face arrière) du substrat 11 jusqu'au fond des tranchées 17. Les tranchées 31 sont par exemple centrées sur les tranchées 17 sous-jacentes. A titre d'exemple, les tranchées 31 ont une largeur inférieure à la largeur des tranchées 17. A titre d'exemple, les tranchées 31 sont formées de façon à former des puces 20, chaque puce 20 comportant un unique plot 15.

Les tranchées 31 sont par exemple réalisées au moyen d'une scie diamantée. Dans un mode de réalisation préféré, les tranchées 31 sont réalisées par gravure plasma, ce qui permet d'éviter des contaminations métalliques et particulaires liées à l'utilisation d'une scie diamantée. D'autres procédés de découpe peuvent être utilisés, par exemple une découpe par laser.

La figure 2E illustre une structure obtenue à l'issue d'une étape de dépôt d'une couche hydrophobe 25 sur la face arrière de la structure illustrée en figure 2D, c'est-à-dire la face supérieure de la structure illustrée en figure 2E. Cette étape est similaire à l'étape de dépôt décrite en relation avec la figure 1E à la différence près que le dépôt est réalisé par la face arrière des puces 20.

La couche 25 est par exemple formée par un dépôt en phase vapeur, par un dépôt liquide à la tournette ou par un dépôt réalisé par immersion dans un bain. A titre d'exemple, selon le mode de dépôt et la nature du matériau de la couche 25, la structure subit un recuit.

A titre d'exemple, la couche 25 est en un composé fluoré. La couche 25 est, par exemple, formée à partir d'une solution à base du composé fluoré connu sous la dénomination commerciale NOVEC 1720. Dans cet exemple, le dépôt peut être assisté d'une activation ultrasonique. Dans cet exemple, la couche 25 subit, après dépôt, un recuit, par exemple de l'ordre de 135°C pendant 15 minutes.

En variante, la couche 25 est formée à partir d'une solution, développée par le fabriquant Daikin et connue sous la dénomination commerciale optool. Dans cet exemple, la couche 25 est séchée par centrifugation.

Encore en variante, la couche 25 est formée à partir d'octadecyltrichlorosilane(OTS) en solution dans de l'isooctane. Dans cet exemple, la couche 25 est séchée par centrifugation.

Encore en variante, la couche 25 est formée à partir de perfluorodecyldimethylchlorosilane en solution dans de l'isooctane. Dans cet exemple, la couche 25 est séchée par centrifugation.

Plus généralement, la couche 25 est formée par dépôt, c'est à dire par addition, par exemple par greffage, d'un matériau hydrophobe sur les parties exposées de la structure, pendant que le substrat 27 est solidaire mécaniquement du substrat 11. Le matériau hydrophobe comprend un ou plusieurs composés de la solution, liquide ou gazeuse, circulant entre les plots pendant l'étape de dépôt.

Lors de cette étape, la couche 25 est déposée sur toute la face supérieure de la structure illustrée en figure 2D et recouvre, la face arrière du substrat 11, les flancs du substrat 11 et de la couche 13 et les portions de la face supérieure de la couche 29 non recouvertes par les plots 15.

A titre d'exemple, les étapes d'individualisation des puces 20 et de dépôt de la couche 25 peuvent être inversées. Ainsi, le dépôt de la couche 25 est réalisé alors que les tranchées 31 ne sont pas formées, la couche 25 revêt alors les flancs et le fond des tranchées 17 et les portions de la face supérieure de la couche 29 non recouvertes par les plots 15, mais ne revêt pas les flancs des tranchées 31.

La figure 2F illustre une structure obtenue à l'issue d'une étape de report de la structure illustrée en figure 2E sur un film support 21 puis de retrait du substrat 27 et de la couche 29.

En figure 2F, la structure est représentée retournée par rapport à la structure illustrée en figure 2E. En figure 2D, la face avant de la structure correspond alors à la face supérieure. A titre d'exemple, la structure est fixée, par sa face arrière, sur la face supérieure du film support 21. Autrement dit, dans cet exemple, les puces 20 sont fixées, par leur face arrière (face inférieure du substrat 11) sur la face supérieure du film support 21.

Le substrat 27 et la couche 29 sont par exemple détachés ou décollés mécaniquement. Du reste de la structure. Pour faciliter le retrait du substrat 27 et de la couche 29, le film support 21 est, par exemple monté sur une table aspirante. A titre d'exemple, le film 21 est choisi de façon à ce que la force d'adhésion des puces 20 sur le film 21 soit supérieure à la force d'adhésion du substrat 27 et de la couche 29 sur les puces 20.

Le détachement du substrat 27 et de la couche 29 peut faire appel à d'autres techniques connues de détachement comme le décollage par laser aussi appelé laser lift-off (LLO), le Smart Cut (fracturation d'une couche implantée enterrée), des gravures chimiques, ou un retrait par rodage du substrat.

A l'issue des étapes décrites ci-avant, chaque puce 20 comprend une différence d'hydrophilie entre ses flancs et sa face avant. Les flancs des puces 20 sont recouverts d'une couche hydrophobe dont l'angle de goutte, pour une goutte d'eau, est, par exemple, supérieur à 60°. La face avant des puces 20 comportent une couche 13 dont la surface est, par exemple, hydrophile et a un angle de goutte, pour une goutte d'eau, par exemple, inférieur à 40°.

A titre d'exemple, lorsque la couche 25 est en NOVEC 1720, la couche 25 a un angle de goutte, pour une goutte d'eau, de l'ordre de 105°.

En variante, lorsque la couche 25 est formée par HF vapeur, la couche 25 a un angle de goutte, pour une goutte d'eau, de l'ordre de 70°.

Encore en variante, lorsque la couche 25 est en optool, la couche 25 a un angle de goutte, pour une goutte d'eau, de l'ordre de 107°.

Encore en variante, lorsque la couche 25 est en OTS, la couche 25 a un angle de goutte, pour une goutte d'eau, de l'ordre de 110°.

Encore en variante, lorsque la couche 25 est en perfluorodecyldimethylchlorosilane, la couche 25 a un angle de goutte, pour une goutte d'eau, de l'ordre de 110°.

A titre d'exemple, la surface de la couche 13 a un angle de goutte, pour une goutte d'eau, inférieur à 10°.

La figure 2G et la figure 2H illustrent des étapes respectivement identiques aux étapes 1G et 1H. Ces étapes correspondent au report et collage d'une puce 20 fabriquée via le procédé des figures 2A à 2F, sur une structure présentant une surface d'accueil présentant un contraste d'hydrophilie similaire, par exemple sur une autre puce 20' fabriquée par le même procédé.

Un avantage du mode de réalisation des figures 2A à 2H est qu'il permet un meilleur contrôle de l'état de surface de la couche 13. Cela réduit la défectivité du collage et permet d'obtenir une surface à l'hydrophilie bien contrôlée . Un autre avantage est l'absence de dégradation de la couche hydrophobe 25 lors du retrait de la couche de résine 19, ce qui permet d'améliorer le contraste hydrophile/hydrophobe et de faciliter l'auto-alignement. En outre, ce procédé permet d'élargir la liste des matériaux hydrophobes disponibles dans la mesure où il n'est plus nécessaire de choisir un matériau résistant au nettoyage chimique mis en oeuvre lors du retrait de la couche 19.

Un autre avantage du présent mode de réalisation est que le substrat 27 peut être recyclé, donc utilisé de nouveau, à l'issu du procédé (en fonction du procédé utilisé pour le retrait du substrat 27).

Encore un autre avantage du présent mode de réalisation est que la découpe décrite en relation avec la figure 2D peut être réalisée par gravure plasma ce qui réduit les contaminations particulaire et métallique par rapport à une découpe mécanique, par exemple avec une scie diamantée. Une découpe par laser est aussi possible avec les mêmes avantages.

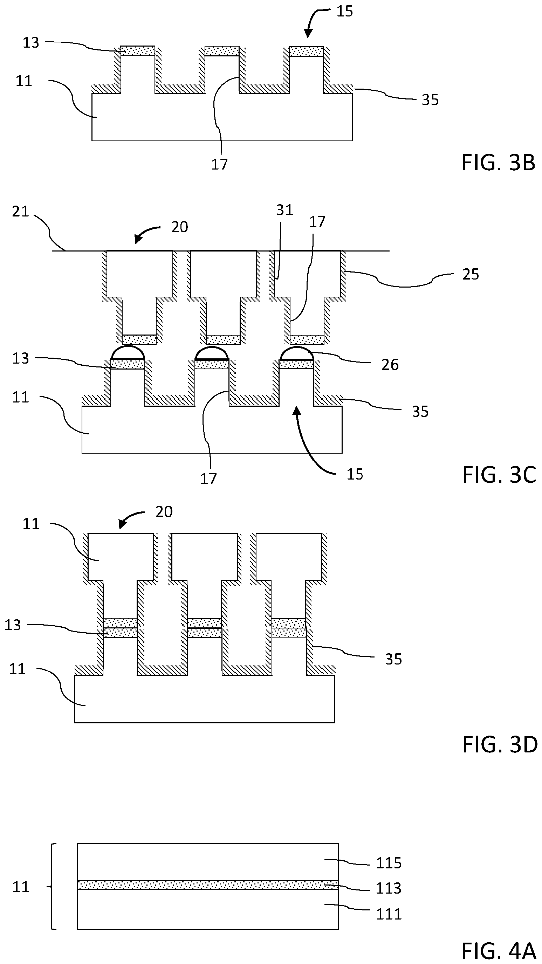

La figure 3A, la figure 3B, la figure 3C et la figure 3D sont des vues en coupe, illustrant de façon partielle et schématique, des étapes successives d'un procédé de fabrication puis d'assemblage de deux structures par collage selon un deuxième mode de réalisation.

Plus particulièrement, dans ce mode de réalisation, on prévoit d'assembler une première structure obtenue à l'issue des étapes des figures 2A à 2F avec une seconde structure obtenue par un procédé similaire à la différence près qu'elle n'a pas subi d'étape de découpe pour la formation des puces 20 individuelles.

Pour réaliser cette seconde structure, on prévoit, dans un premier temps, de déposer une couche hydrophobe 35 sur la face arrière de la structure illustrée en figure 2C et ainsi aboutir à la structure illustrée en figure 3A. Cette étape est similaire à l'étape de dépôt de la couche 25 à la différence près que la couche 35 est formée sur la structure illustrée en figure 2C et non sur la structure illustrée en figure 2D.

A l'issue de cette étape, dans un deuxième temps, le substrat 27 et la couche 29 sont retirés pour former la structure illustrée en figure 3B similairement à ce qui a été décrit en relation avec la figure 2F.

La structure illustrée en figure 2F et la structure illustrée en figure 3B sont alors assemblées et auto-alignées par confinement d'eau.

La figure 3C représente une structure obtenue à l'issu du dépôt de gouttes d'eau 26 à la surface des plots 15 de la structure illustrée en figure 3B et le report, sur celle-ci, de la structure illustrée en figure 2F, les couches 13 des deux structures se faisant face. La figure 3D représente une structure obtenue à l'issu du collage de ces deux structures.

Ces étapes sont similaires à ce qui a été décrit à l'échelle d'une puce en relation avec les figures 2G et 2H, elles ne sont donc pas décrites de nouveau ci-après.

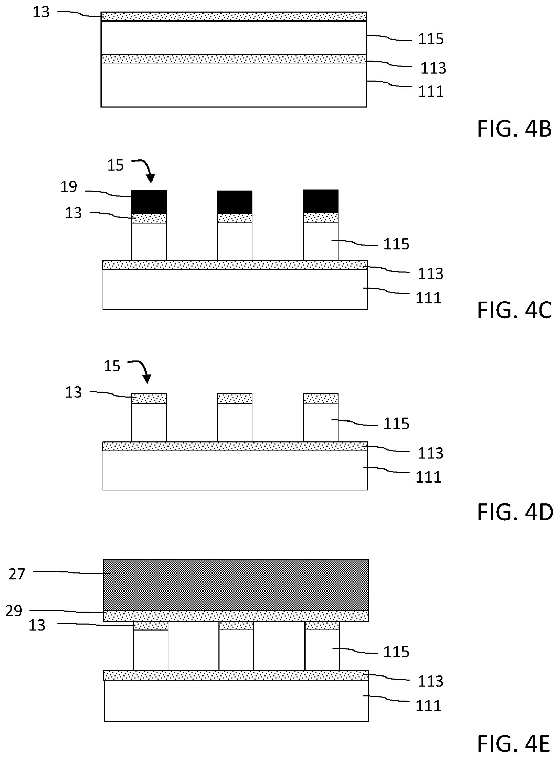

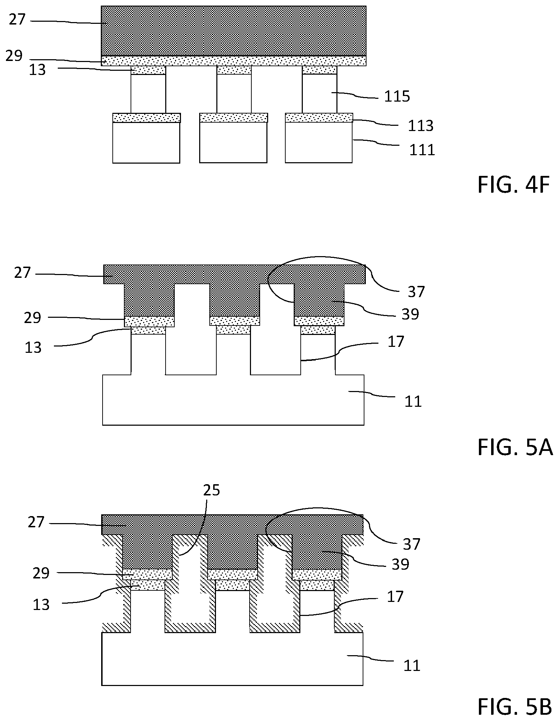

La figure 4A, la figure 4B, la figure 4C, la figure 4D, la figure 4E et la figure 4F sont des vues en coupe, illustrant de façon partielle et schématique, des étapes successives d'un procédé de fabrication puis d'assemblage de deux structures par collage selon un troisième mode de réalisation.

Le troisième mode de réalisation est similaire au premier mode de réalisation illustré en relation avec les figures 2A à 2H à la différence près que le substrat de départ 11 correspond à un substrat dit SOI (de l'anglais "Semiconductor On Insulator", semiconducteur sur isolant).

Le procédé décrit en figures 4A à 4F comprend des étapes similaires à certaines étapes du procédé décrit en relation avec les figures 2A à 2H. Ces étapes ne seront pas détaillées à nouveau ci-après. Seules les différences avec le procédé des figures 2A à 2H seront mises en exergue.

La figure 4A illustre un substrat 11 de départ comportant une couche d'oxyde 113, par exemple en dioxyde de silicium, entre deux niveaux semiconducteurs, par exemple en silicium. Le substrat 11 comprend un niveau semiconducteur inférieur ou couche semiconductrice 111, et un niveau semiconducteur supérieur ou couche semiconductrice 115. Le niveau semiconducteur supérieur 115 a, par exemple une épaisseur comprise entre 5 µm et 20 µm, par exemple de l'ordre de 10 µm. La couche de dioxyde de silicium a, par exemple, une épaisseur comprise entre 0,2 µm et 5 µm, par exemple de l'ordre de 1 µm. Le niveau semiconducteur inférieur 111 a par exemple une épaisseur comprise entre 100 µm et 1 mm, par exemple comprise entre 500 µm et 800 µm, par exemple de l'ordre de 725 µm.

La figure 4B illustre une structure obtenue à l'issue d'une étape de dépôt d'une couche 13 sur la face supérieure du substrat 11 similairement à ce qui a été décrit en relation avec le premier mode de réalisation en figure 2A à la différence près que le substrat 11 est un substrat SOI.

La figure 4C illustre une structure obtenue à l'issue d'une étape de formation de plots 15 dans la structure de la figure 4B. Cette étape est similaire à ce qui a été décrit en relation avec le premier mode de réalisation en figure 2A à la différence près que la couche 113 joue le rôle de couche d'arrêt de la gravure. Ainsi, la hauteur des plots 15 est définie par l'épaisseur du niveau semiconducteur supérieur 115 du substrat SOI.

La figure 4D illustre une structure obtenue à l'issue d'une étape de retrait de la couche 19 de la structure illustrée en figure 4C. Cette étape est similaire à ce qui a été décrit en relation avec le premier mode de réalisation en figure 2B.

La figure 4E illustre une structure obtenue à l'issue d'une étape de report du substrat 27 et de la couche 29 sur la face supérieure de la structure illustrée en figure 4D. Cette étape est similaire à ce qui a été décrit en relation avec la figure 2C.

La figure 4F illustre une structure obtenue à l'issue d'une étape de formation des tranchées 23. L'étape de formation des tranchées 23 décrite dans ce présent mode de réalisation est similaire à l'étape de formation des tranchées 23 décrite en relation avec le premier mode de réalisation en figure 2D à la différence près qu'elle est réalisée en deux étapes et qu'elle comprend, en plus de la gravure du substrat 11, une autre gravure permettant la gravure de la couche 113. Lors de la première étape, seul le niveau inférieur 111 du substrat SOI est gravé, la couche 113 servant de couche d'arrêt de gravure. Ceci permet de limiter la détérioration du substrat 27.

A l'issue de cette étape, des étapes similaires aux étapes des figures 2E à 2G sont mises en oeuvre à partir de la figure illustrée en figure 4F.

La figure 5A et la figure 5B sont des vues en coupe, illustrant de façon partielle et schématique, des étapes successives d'un procédé de fabrication puis d'assemblage de deux structures par collage selon un quatrième mode de réalisation.

La figure 5A illustre une structure similaire à la structure illustrée en figure 2C à la différence près que, le substrat 27 comprend des tranchées 37, formées à partir de sa face inférieure dans l'orientation de la figure 5A. En effet, avant l'étape de report du substrat 27 et de la couche 29 sur la structure illustrée en figure 2B, l'ensemble formé du substrat 27 et de la couche 29 est structuré, par exemple par gravure, de façon à former des tranchées 37 délimitant des plots 39. A titre d'exemple, les tranchées 37 sont non traversantes et s'étendent, par exemple de la face inférieure de la couche 29, dans la couche et dans une partie du substrat 27. A titre d'exemple les plots 39 ont le même pas de répétition (distance centre à centre entre deux plots voisins) que les plots 15. A titre d'exemple, le motif formé par les plots 39 dans le substrat 27 correspond à la symétrie du motif formé par les plots 15 dans le substrat 11, par rapport à un plan parallèle aux faces arrières des substrats 11 et 27 et passant entre les deux substrats. A titre d'exemple, les tranchées 37 s'étendent sur une profondeur comprise entre 50 µm et 600 µm, par exemple comprise entre 200 µm et 400 µm, par exemple de l'ordre de 300 µm.

La figure 5B illustre une structure obtenue à l'issue d'une étape de dépôt de la couche hydrophobe 25. Cette étape est similaire à ce qui a été décrit en relation avec la figure 3A.

A l'issue de cette étape, des étapes similaires aux étapes des figures 3B à 3D sont mises en oeuvre à partir de la figure illustrée en figure 5B.

Un avantage du présent mode de réalisation réside dans le fait que la présence des tranchées 37 facilite la circulation et le dépôt homogène du matériau hydrophobe lors de la formation de la couche 25. Ceci est tout particulièrement avantageux lorsque l'épaisseur des plots 15 est faible.

Dans l'exemple représenté, les plots 39 ont une surface supérieure à celle des plots 15. Ainsi, la face supérieure de chaque plot 15 est entièrement couverte par le plot 39 sus-jacent lors du traitement hydrophobe, de sorte que le matériau hydrophobe est formé uniquement sur les flancs des plots 15.

A titre de variante, les plots 39 ont une surface inférieure à celle des plots 15. Ainsi, seule une partie centrale de la face supérieure de chaque plot 15 est couverte par le plot 39 sus-jacent lors du traitement hydrophobe. Le matériau hydrophobe est alors formé sur les flancs des plots 15 et sur une partie périphérique de la face supérieure des plots 15.

On notera par ailleurs que dans ce mode de réalisation, les tranchées 17 peuvent être omise. Dans ce cas, l'épaisseur des plots 15 est nulle. La surface de chaque plot 15 correspond alors à la surface totale de la puce 20 à l'issue de l'étape de découpe. Si le traitement hydrophobe est mis en oeuvre avant la découpe (c'est à dire avant la formation des tranchées 31), les plots 39 ont de préférence une surface inférieure à celle des plots 15. Il en résulte que seule une partie centrale de la face supérieure de chaque plot 15 est couverte par le plot 39 sus-jacent lors du traitement hydrophobe. Le matériau hydrophobe est alors formé uniquement sur une partie périphérique de la face supérieure des plots 15. Si le traitement hydrophobe est mis en oeuvre après la découpe (c'est à dire après la formation des tranchées 31), les plots 39 peuvent avoir une surface inférieure ou supérieure à celle des plots 15.

Divers modes de réalisation et variantes ont été décrits. La personne du métier comprendra que certaines caractéristiques de ces divers modes de réalisation et variantes pourraient être combinées, et d'autres variantes apparaîtront à la personne du métier. En particulier, les modes de réalisation décrits ne se limitent pas aux exemples de matériaux et de dimensions mentionnés dans la présente description. Aussi, les modes de réalisation des figures 3, 4 et 5 peuvent être combinés.

De plus, les modes de réalisations ont été décrit pour un collage hydrophile toutefois ils peuvent être mis en oeuvre pour des collages hydrophobes. Autrement dit, au lieu de prévoir une structure présentant une surface avant hydrophile, la face avant de la structure peut être hydrophobe, à condition que la couche 25 ou 35 déposée sur les flancs de la structure soit plus hydrophobe que la face avant.

Dans ce sens, un exemple (non limitatif) de collage hydrophobe va maintenant être décrit. Dans cet exemple, on propose de fabriquer une structure similaire à la structure illustrée en figure 2B à la différence près qu'elle ne comprend pas de couche 13. A l'issue de l'étape de nettoyage de la face supérieure des plots 15, on propose un nouveau nettoyage permettant de désoxyder la surface des plots 15. Pour cela, elle subit un traitement à base de HF vapeur ou gazeux. A l'issu de ce nettoyage, la face supérieure des plots 15 a un angle de goutte, pour une goutte d'eau de l'ordre de 70°. Dans cet exemple, un substrat 27 est également reporté sur la face supérieure des plots 15 à la différence près que la face inférieure du substrat 27 n'est pas recouvert d'une couche d'oxyde 27 comme cela a été décrit en relation avec le premier mode de réalisation. Dans cet exemple, avant l'étape de report du substrat 27 sur la face supérieure des plots 15, la face inférieure du substrat 27 subit un même nettoyage permettant de désoxyder sa surface. A la suite du report du substrat destiné à protéger la face avant des puces, des étapes similaires à ce qui a été décrit en relation avec les figures 2D à 2H sont réalisées. Le collage de deux puces formées par ce procédé, est alors dit hydrophobe puisque les faces avant des puces sont hydrophobe. Dans cet exemple, les faces avant des puces ont un angle de goutte, pour une goutte d'eau de l'ordre de 70° et les flancs des puces ont un angle de goutte, pour une goutte d'eau de l'ordre de 110°. Dans ce cas, la différence d'hydrophilie est d'environ 40° en angle de goutte. Plus généralement, ce procédé peut s'étendre à la fabrication de puces, destinées à un collage par confinement d'eau, si la différence d'hydrophilie entre sa face avant et ses flancs est supérieure à 20°, par exemple supérieure à 30°, par exemple supérieure à 40° en angle de goutte, pour une goutte d'eau.

En variante, on peut prévoir de rendre la face avant du substrat 11 et celle du substrat 27 hydrophobe par le dépôt d'une couche hydrophobe, par exemple moins hydrophobe que la couche 25. A titre d'exemple, on peut prévoir le dépôt d'une couche en silicium, par exemple d'une épaisseur de l'ordre de 5 nm, sur la face avant du substrat 11 et du substrat 27. Dans cette variante, la couche hydrophobe déposée sur la face avant du substrat 11 et du substrat 27 est, par exemple, nettoyée à base d'un mélange d'acide sulfurique et d'eau oxygénée dans les proportions 10 pour 1 puis rincée et de nouveau nettoyée à base d'un mélange porté à 50°C d'eau, d'ammoniaque et d'eau oxygénée dans les proportions un pour cinq pour cinq.

De plus, dans la présente description, le collage correspond à un collage par confinement de goutte d'eau. Toutefois on peut prévoir que le collage se fasse par confinement d'une goutte d'un autre liquide.

Par ailleurs, dans la description on considère un collage de deux puces, toutefois elle peut être généralisable au collage de deux structures quelconques électroniques ou non.

Enfin, la mise en oeuvre pratique des modes de réalisation et variantes décrits est à la portée de la personne du métier à partir des indications fonctionnelles données ci-dessus.

## Revendications

1. Procédé de fabrication d'une structure destinée à être assemblée avec une autre structure par collage auto-aligné par contraste d'hydrophilie, comportant les étapes successives suivantes :
a) définition de plots (15) du côté d'une première face d'un premier substrat (11) ;
b) report d'un deuxième substrat (27) du côté de la première face du premier substrat (11) ;
c) dépôt, sur les flancs et/ou sur une partie périphérique de la face supérieure des plots (15), d'un matériau (25) plus hydrophobe qu'un matériau de la face supérieure des plots ; et
d) après l'étape c), retrait du deuxième substrat (27).

2. Procédé selon la revendication 1, dans lequel le matériau de la face supérieure des plots (15) et le matériau (25) revêtant le flanc des plots (15) présentent une différence d'angle de contact de goutte d'eau supérieure à 20°.

3. Procédé selon la revendication 1 ou 2, dans lequel le premier substrat (11) comprend un matériau semiconducteur.

4. Procédé selon la revendication 3, dans lequel le premier substrat (11) est un substrat de type semiconducteur sur isolant.

5. Procédé selon l'une quelconque des revendications 1 à 4, dans lequel la première face du premier substrat (11) est revêtue d'une couche d'oxyde (13).

6. Procédé selon la revendication 5, dans lequel la couche d'oxyde (13) sur le premier substrat (11) comprend des plots de connexion métalliques.

7. Procédé selon l'une quelconque des revendications 1 à 6, dans lequel, à l'étape b), le deuxième substrat (27) est fixé au premier substrat (11) par collage moléculaire.

8. Procédé selon l'une quelconque des revendications 1 à 7, dans lequel l'étape c) est réalisée par traitement HF vapeur.

9. Procédé selon l'une quelconque des revendications 1 à 7, dans lequel l'étape c) est réalisée par immersion de la structure dans un bain à base d'un composé fluoré.

10. Procédé selon l'une quelconque des revendications 1 à 7, dans lequel l'étape c) est réalisée par immersion de la structure dans un bain à base du mélange connu sous la dénomination commerciale optool, à base de octadecyltrichlorosilaneou à base de perfluorodecyldimethylchlorosilane.

11. Procédé selon l'une quelconque des revendications 1 à 10, comportant, avant l'étape c), une étape de découpe du premier substrat (11), de façon à former des puces (20), chaque puce comportant un plot (15).

12. Procédé selon l'une quelconque des revendications 1 à 11, comportant, après l'étape a), une étape de nettoyage de la première face du premier substrat (11).

13. Procédé selon l'une quelconque des revendications 1 à 12, dans lequel le deuxième substrat (27) est structuré de façon à présenter un plot (39) d'épaisseur non nulle en vis à vis de chaque plot (15) du premier substrat (11).

14. Procédé selon l'une quelconque des revendications 1 à 13, dans lequel les plots (15) du premier substrat (11) ont une épaisseur non nulle.

15. Procédé de collage d'une première structure et d'une deuxième structure fabriquée par le procédé décrit selon l'une quelconque des revendications 1 à 12 comportant une étape de dépôt d'une goutte d'eau (36) sur la première face du premier substrat (11) de la première structure et une étape de report de la deuxième structure sur la première structure, les premières faces des premiers substrats (11) se faisant face.
